# FASCICULE DE BREVET EUROPEEN

(11) **EP 3 312 983 B1**
(45) Date de publication et mention de la délivrance du brevet: **09.10.2024**
(21) Numéro de dépôt: 17197817.4
(22) Date de dépôt: 23.10.2017
(51) Int. Cl.: H02M 7/00

(54) **CONVERTISSEUR DE TENSION DESTINÉ À ALIMENTER EN PUISSANCE UNE MACHINE ÉLECTRIQUE POUR VÉHICULE AUTOMOBILE**
SPANNUNGSWANDLER ZUR LEISTUNGSVERSORGUNG EINER ELEKTRISCHEN MASCHINE FÜR KRAFTFAHRZEUGE
VOLTAGE CONVERTER FOR SUPPLYING POWER TO AN ELECTRIC MACHINE FOR A MOTOR VEHICLE

(30) Priorité: 21.10.2016 FR 1660235
(43) Date de publication de la demande: 25.04.2018
(60) Demande divisionnaire: 24192477.8
(73) Titulaire: Valeo Electrification, 95800 Cergy (FR)
(72) Inventeur: FALGUIER, Manuel, 94046 CRETEIL (FR); SANCHES, Michael, 94046 CRETEIL (FR); BAUDESSON, Philippe, 95892 CERGY PONTOISE (FR)
(74) Mandataire: Valeo Powertrain Systems

(56) Documents cités:
- EP-A1- 2 717 455
- JP-A- 2002 084 790
- JP-A- 2016 135 071
- US-A1- 2013 039 100
- US-A1- 2014 345 492
- US-A1- 2015 313 040
- MARTY BROWN: "Considerations in Designing the Printed Circuit Boards of Embedded Switching Power Supplies", INTERNET CITATION, 30 August 2000 (2000-08-30), pages 1 - 8, XP002512584, Retrieved from the Internet <URL:http://web.archive.org/web/20000831125718/http://www.fairchildsemi.com/an/AN/AN-1031.pdf> [retrieved on 20080127]

## Description

L'invention concerne un convertisseur de tension, notamment destiné à alimenter en puissance une machine électrique pour véhicule automobile.

L'invention concerne également un équipement électrique comprenant une machine électrique et un tel convertisseur de tension.

En général, un moteur électrique, notamment pour véhicule automobile, comprend un convertisseur de tension, supporté par un châssis, comprenant des unités électroniques de puissance contrôlées par une unité électronique de contrôle.

Le convertisseur de tension peut également comprendre un bloc de condensateurs configuré pour stabiliser une tension électrique reçue par les unités électroniques de puissance et pour réduire les perturbations électromagnétiques générées par les unités électroniques de puissance et de contrôle.

En général, le bloc de condensateurs est intégré au sein du convertisseur de tension à distance des unités électroniques de puissance, les condensateurs du bloc de condensateurs étant volumineux.

Cependant, la distance entre le bloc de condensateurs et les unités électroniques de puissance induit la présence d'une capacité parasite au sein du convertisseur de tension.

Afin de réduire, voire supprimer cette capacité parasite, il existe des convertisseurs de tension dans lesquels les unités électroniques de puissance comprennent des condensateurs en céramique, intégrés directement au sein des unités électroniques de puissance, de sorte à filtrer la tension d'entrée des unités électroniques de puissance. Cependant, cette solution technique est coûteuse et entraine une modification du procédé d'assemblage des unités électroniques de puissance, notamment par l'ajout d'une étape de collage des condensateurs en céramique sur les unités électroniques de puissance.

Il existe également des convertisseurs de tension comprenant un connecteur électrique configuré pour connecter électriquement les condensateurs du bloc de condensateurs aux unités électroniques de puissance. Cependant, cette solution technique est couteuse et volumineuse. En effet, comme les condensateurs et les unités électroniques de puissance ne présentent pas les mêmes dimensions, le connecteur électrique présente un design particulier qui est difficile à intégrer au sein du convertisseur de tension.

Le document US 2014/345492 A1 concerne l'équipement de commande de conduite d'un véhicule ferroviaire.

Ledocument MARTY BROWN: "Considérations in Designing the Printed Circuit Boards of Embedded Switching Power Supplies", INTERNET CITATION, 30 août 2000 (2000-08-30), pages 1-8, XP002512584, traite des considérations relatives à la conception des cartes de circuits imprimés des alimentations à découpage intégrées.

Le document US 2015/313040 A1 concerne un convertisseur de puissance qui convertit la puissance d'entrée en un type spécifique de puissance et produit la puissance résultant de la conversion.

Le document JP 2002 084790 A divulgue un convertisseur de tension tel que définit dans le préambule de chacune des revendications 1 et 2.

Le document US 2013/039100 A1 concerne une technologie pour réduire le bruit des convertisseurs de puissance représentée par un onduleur, un convertisseur et similaire.

Le document EP 2 717 455 A1 concerne un dispositif ou un appareil de conversion de puissance permettant de réduire une distance de câblage entre des condensateurs à filtre et des moyens de commutation.

Le document JP 2016 135071 A vise à fournir un module de barre omnibus capable d'éliminer de manière appropriée un bruit de commutation lors de la connexion d'éléments de commutation et à fournir un circuit électrique comprenant le module de barre omnibus.

La présente invention vise à remédier à ces inconvénients en proposant un convertisseur de tension permettant de minimiser la distance entre le bloc de condensateurs et les unités électroniques de puissance, et par conséquent de réduire les perturbations électromagnétiques au sein du convertisseur de tension, sans en augmenter le coût et l'encombrement.

L'invention est définie par un convertisseur de tension, tel que défini dans la revendication 1. D'autres modes de réalisation préférés sont définis dans les revendications dépendantes.

A cet effet, l'invention a pour objet un convertisseur de tension, notamment destiné à alimenter en puissance une machine électrique pour véhicule automobile, comprenant :
- au moins deux unités électroniques de puissance configurées pour convertir une tension électrique, chaque unité électronique de puissance comprenant deux bras de commutation,
- un bloc de filtrage configuré pour filtrer la tension électrique d'entrée de l'unité électronique de puissance,

les au moins deux unités électroniques de puissance et le bloc de filtrage étant connectés électriquement via chaque bras de commutation desdites unités électroniques de puissance, et
dans lequel les distances entre chaque bras de commutation et le bloc de filtrage sont sensiblement identiques.

Avantageusement, la configuration du convertisseur de tension selon l'invention, et notamment une distance sensiblement identique entre les unités électroniques de puissance et le bloc de filtrage, permet de réduire les perturbations électromagnétiques parasites émises par les unités électroniques de puissance au sein du convertisseur de tension, et par conséquent d'optimiser la compatibilité électromagnétique entre le convertisseur de tension et la machine électrique.

Le convertisseur de tension selon l'invention peut également comprendre une ou plusieurs des caractéristiques suivantes, considérées individuellement ou selon toutes les combinaisons possibles :
- le bloc de filtrage comprenant au moins deux unités de filtrage, la distance minimale entre les bras de commutation d'une unité électronique de puissance et une unité de filtrage est sensiblement identique à la distance minimale entre les bras de commutation de l'autre unité électronique de puissance et l'autre unité de filtrage ; et/ou
- le bloc de filtrage comprenant au moins deux unités de filtrage, la distance minimale entre les bras de commutation d'une unité électronique de puissance et l'unité de filtrage à laquelle lesdits bras sont connectés est sensiblement identique à la distance minimale entre les bras de commutation de l'autre unité électronique de puissance et l'unité de filtrage à laquelle les bras de commutation de l'autre unité électronique de puissance sont connectés ; et/ou
- le bloc de filtrage comprenant au moins deux unités de filtrage, les distances minimales entre chaque bras de commutation des unités électroniques de puissance et l'unité de filtrage à laquelle chacun des dits bras de commutation est connecté sont sensiblement identiques ; et/ou
- la distance minimale entre chaque bras de commutation de chaque unité électronique de puissance et une unité de filtrage est inférieure à 10 mm ; et/ou
- la distance minimale entre chaque bras de commutation de chaque unité électronique de puissance et l'unité de filtrage à laquelle chaque bras de commutation est connecté est inférieure à 10 mm ; et/ou
- le convertisseur de tension comprend également un connecteur électrique configuré pour connecter électriquement le bloc de filtrage à chaque bras de commutation de chaque unité électronique de puissance ; et/ou
- les au moins deux unités électroniques de puissance sont agencées l'une à côté de l'autre, et dans lequel le bloc de filtrage s'étend longitudinalement le long de la direction d'agencement des unités électroniques de puissance de sorte que les distances entre chaque bras de commutation et le bloc de filtrage sont sensiblement identiques ; et/ou
- le convertisseur de tension comprend au moins trois unités électroniques de puissance, et dans lequel les au moins trois unités électroniques de puissance sont alignées les unes à côté des autres, et dans lequel le bloc de filtrage s'étend sensiblement parallèlement à la direction d'alignement des unités électroniques de puissance de sorte que les distances entre chaque bras de commutation de chaque unité électronique de puissance et le bloc de filtrage sont sensiblement identiques ; et/ou
- le bloc de filtrage comprenant au moins une unité de filtrage, telle que les au moins deux unités électroniques de puissance sont séparées par la au moins une unité de filtrage de sorte que les distances minimales entre chaque bras de commutation et l'unité de filtrage sont sensiblement identiques ; et/ou
- le bloc de filtrage comprenant au moins une unité de filtrage, telle que les au moins deux unités électroniques de puissance sont séparées par la au moins une unité de filtrage de sorte que les distances minimales entre chaque bras de commutation et l'unité de filtrage à laquelle chaque bras de commutation est connecté sont sensiblement identiques ; et/ou
- le convertisseur de tension comprend au moins trois unités électroniques de puissance, le bloc de filtrage comprenant au moins trois unités de filtrage, une unité électronique de puissance étant séparée d'une autre unité électronique de puissance par une unité de filtrage de sorte que les distances minimales entre chaque bras de commutation de chaque unité électronique de puissance et une unité de filtrage sont sensiblement identiques ; et/ou
- le convertisseur de tension comprend au moins trois unités électroniques de puissance, le bloc de filtrage comprenant au moins trois unités de filtrage, une unité électronique de puissance étant séparée d'une autre unité électronique de puissance par une unité de filtrage de sorte que les distances minimales entre chaque bras de commutation de chaque unité électronique de puissance et l'unité de filtrage à laquelle chaque bras de commutation est connecté sont sensiblement identiques ; et/ou
- les unités électroniques de puissance sont régulièrement réparties le long d'une courbe fermée, une unité de filtrage étant disposée entre deux unités électroniques de puissance successives ; et/ou
- le convertisseur de tension comprend également un dissipateur thermique comprenant un support de réception des au moins deux unités électroniques de puissance et du bloc de filtrage, le support de réception comprend au moins une cavité de réception du bloc de filtrage et une zone de réception respective de chaque unité électronique de puissance ; et/ou
- le dissipateur thermique comprend également un couvercle et un joint métallique, le joint métallique étant agencé entre le support de réception et le couvercle ; et/ou
- le dissipateur thermique comprend un circuit de refroidissement comportant un canal de circulation d'un fluide de refroidissement ; et/ou
- le bloc de filtrage comprenant au moins une unité de filtrage comprenant une partie inférieure sensiblement plane agencée en vis-à-vis du fond de ladite cavité de réception et une paroi latérale s'étendant depuis la partie inférieure dans une direction sensiblement perpendiculaire à ladite partie inférieure, le circuit de refroidissement comprenant une première portion s'étendant sensiblement parallèlement à la paroi latérale de la au moins une unité de filtrage, la première portion du circuit de refroidissement étant adjacente à la paroi latérale de l'unité de filtrage ; et/ou
- la première portion comprend une face externe d'une paroi latérale du canal de circulation du fluide de refroidissement ; et/ou
- le support de réception comprend un premier et un deuxième plans d'appui, le premier plan d'appui comprenant au moins une cavité de réception du bloc de filtrage et le deuxième plan d'appui comprenant au moins une zone de réception d'une unité électronique de puissance, le circuit de refroidissement comprenant une première partie s'étendant sensiblement parallèlement au premier plan d'appui et une deuxième partie s'étendant sensiblement parallèlement au deuxième plan d'appui ; et/ou
- chaque unité électronique de puissance comprenant un substrat plan comprenant une face supérieure et une face inférieure, la face inférieure de chaque unité électronique de puissance étant agencée en vis à vis de la zone de réception du dissipateur thermique, le circuit de refroidissement comprenant une deuxième portion s'étendant sensiblement parallèlement à la face inférieure de chaque unité électronique de puissance, l'unité électronique de puissance, la zone de réception et la deuxième portion du circuit de refroidissement étant superposés les uns sur les autres ; et/ou
- la deuxième portion comprend une face externe d'une paroi de fond du canal de circulation du fluide de refroidissement ; et/ou
- une unité électronique de puissance comprend un module électronique de puissance, et une unité de filtrage comprend deux condensateurs.

Avantageusement, une distance minimale entre les bras de commutation des unités électroniques de puissance et le bloc de filtrage permet de limiter la création d'une capacité parasite, et par conséquent de limiter les perturbations électromagnétiques émises au sein du convertisseur de tension.

De plus, un convertisseur de tension selon l'invention comprenant un dissipateur thermique comprenant une première portion s'étendant parallèlement à la paroi latérale d'une unité de filtrage du bloc de filtrage et une deuxième portion s'étendant parallèlement à chaque unité électronique de puissance permet un refroidissement efficace des unités électroniques de puissance et du bloc de filtrage du convertisseur de tension. En outre, un tel dissipateur thermique permet une simplification du procédé de fabrication du convertisseur de tension, sans induire une perte de charge au niveau des unités de filtrage du bloc de filtrage.

De façon avantageuse, un convertisseur de tension selon l'invention comprenant un dissipateur thermique qui comprend différents plans d'appui permet de compenser la différence de dimension entre les unités électroniques de puissance et les unités de filtrage. En effet, dans un tel convertisseur de tension les connections électriques entre les unités électroniques de puissance et les unités de filtrage sont minimisées, et par conséquent les pertes électromagnétiques susceptibles d'être générées au sein du convertisseur de tension sont limitées.

L'invention se rapporte également à un équipement électrique comprenant une machine électrique et un convertisseur de tension selon l'invention destiné à contrôler une énergie électrique échangée entre la machine électrique et un réseau électrique extérieur, et dans lequel le convertisseur de tension est monté sur la machine électrique.

D'autres caractéristiques et avantages de la présente invention apparaitront à la lecture de la description détaillée de modes de réalisation donnés à titre d'exemples non limitatifs et illustrés, accompagnée des figures suivantes :
- la figure 1 représente une vue de dessus d'un convertisseur de tension selon un mode de réalisation de l'invention,
- la figure 2 représente une vue de dessus d'un convertisseur de tension selon un exemple,
- les figures 3 et 5 représentent des vues éclatées de convertisseurs de tension selon des modes de réalisation de l'invention,
- les figures 4 et 6 représentent des vues éclatées de convertisseurs de tension selon un exemple,
- la figure 7 représente une vue éclatée d'un dissipateur thermique d'un convertisseur de tension selon un mode de réalisation de l'invention, et
- les figures 8 et 9 représentent des vues en coupe de deux convertisseurs de tension selon un mode de réalisation de l'invention.

Il est à noter que ces dessins n'ont d'autre but que d'illustrer le texte de la description et ne constituent en aucune sorte une limitation de la portée de l'invention L'invention est définie par les revendications annexées.

Sur les différentes figures, les éléments analogues sont désignés par des références identiques.

L'invention concerne un équipement électrique, notamment pour véhicule automobile, comprenant une machine électrique et un convertisseur de tension.

En particulier, le convertisseur de tension peut être monté sur la machine électrique.

Le convertisseur de tension est destiné à contrôler une énergie électrique échangée entre la machine électrique et une source d'alimentation électrique.

Le convertisseur de tension peut être embarqué dans un véhicule automobile. Le convertisseur de tension peut être par exemple un onduleur de tension.

La source d'alimentation électrique peut être un réseau électrique extérieur, notamment un réseau électrique d'un véhicule automobile. Un réseau électrique est par exemple un réseau électrique alimenté par une tension électrique de +48V. De préférence, le réseau électrique est un réseau d'énergie électrique continue. Le réseau électrique peut comprendre une batterie alimentant ledit réseau électrique.

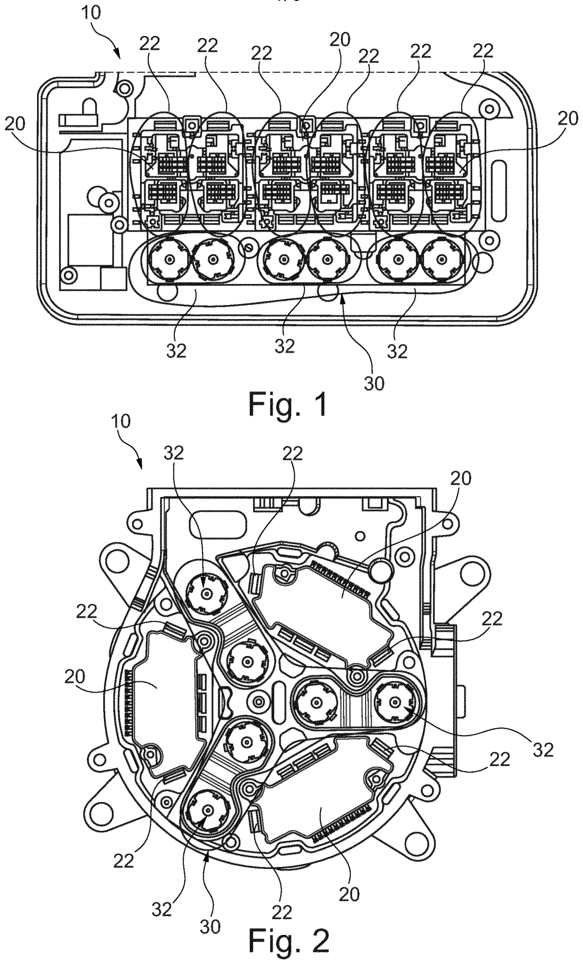

Deux exemples d'un convertisseur de tension 10 sont représentés sur les figures 1 (selon l'invention) et 2.

Le convertisseur de tension 10 est notamment destiné à alimenter en puissance une machine électrique pour véhicule automobile.

Un convertisseur de tension 10 comprend au moins deux unités électroniques de puissance 20, par exemple trois unités électroniques de puissance 20 sur les figures 1 et 2, configurées pour convertir une tension électrique. En particulier, une unité électronique de puissance peut convertir une tension alternative en une tension continue, et inversement.

Une unité électronique de puissance 20 peut être un module électronique de puissance.

Une unité électronique de puissance 20 peut comprendre un ou une pluralité de composants électroniques, par exemple une pluralité de puces électroniques semiconductrices, notamment des puces nues, montés sur un substrat plan.

En particulier, une unité électronique de puissance 20 peut comprendre une ou une pluralité de traces de puissance.

Une trace de puissance peut être connectée électriquement à la pluralité de composants électroniques.

Une trace de puissance est une trace conductrice électriquement, notamment métallique, par exemple en cuivre. Une trace de puissance peut être une lame métallique ou un barreau métallique. Une trace de puissance est destinée à transmettre un courant électrique entre la source d'alimentation électrique et la machine électrique.

Par exemple, une unité électronique de puissance 20 peut comprendre une première trace de puissance, une deuxième trace de puissance et une troisième trace de puissance. La première trace de puissance peut être reliée électriquement à un premier pôle du réseau électrique, par exemple, à un pôle de polarité positive +48V. La deuxième trace de puissance peut être reliée électriquement à un deuxième pôle du réseau électrique, par exemple, à un pôle de polarité négative -48V ou à la masse de la source d'alimentation électrique, par exemple égale à 0V. La troisième trace de puissance peut être reliée électriquement à une phase (ϕ) de la machine électrique. Les première, deuxième et troisième traces de puissance sont distinctes l'une de l'autre et peuvent être en partie surmoulées de matériau isolant électriquement, par exemple de matériau plastique.

Le convertisseur de tension 10 comprend un bloc de filtrage 30 configuré pour filtrer la tension électrique d'entrée de l'unité électronique de puissance 20. Un bloc de filtrage 30 peut comprendre un ou une pluralité d'éléments de filtrage, par exemple une pluralité de condensateurs.

Chaque unité électronique de puissance 20 comprend deux bras de commutation 22. Un bras de commutation 22 peut comprendre des portions de traces de puissance et des composants électroniques.

Les bras de commutation 22 d'une unité électronique de puissance 20 permettent de faire commuter l'unité électronique de puissance 20 entre deux états. En particulier, lors du démarrage du moteur électrique du véhicule automobile, les unités électroniques de puissance requièrent une alimentation en énergie électrique importante. Les traces de puissance des unités électroniques de puissance sont connectées électriquement à des condensateurs du bloc de filtrage, qui permettent, à la place de la batterie du véhicule, de fournir temporairement une alimentation en énergie électrique nécessaire aux unités électroniques de puissance lors d'un besoin important en puissance, notamment lors du démarrage du moteur électrique. Les bras de commutation 22 des unités électroniques de puissance permettent de faire commuter les unités électroniques de puissance 20 entre ces deux états.

Les unités électroniques de puissance 20 et le bloc de filtrage 30 sont connectés électriquement via chaque bras de commutation 22 des unités électroniques de puissance 20.

Les distances entre chaque bras de commutation 22 des unités électroniques de puissance 20 et le bloc de filtrage 30 sont sensiblement identiques.

Par distance sensiblement identique entre chaque bras de commutation des unités électroniques de puissance et le bloc de filtrage, on entend que la distance entre les bras de commutation d'une première unité électronique de puissance et du bloc de filtrage peut être supérieure ou égale à 85% de la distance entre les bras de commutation d'une deuxième unité électronique de puissance et du bloc de filtrage et inférieure ou égale à 115% de la distance entre les bras de commutation de la deuxième unité électronique de puissance et du bloc de filtrage. Préférentiellement, la distance entre les bras de commutation de la première unité électronique de puissance et du bloc de filtrage peut être comprise entre 95% et 105% de la distance entre les bras de commutation de la deuxième unité électronique de puissance et du bloc de filtrage.

En limitant la différence entre les distances entre les bras de commutation des unités électroniques de puissance et les unités de filtrage du bloc de filtrage, les perturbations électromagnétiques susceptibles d'apparaitre lors d'une circulation de courant dans les traces de puissance des unités électroniques de puissance sont limitées.

De préférence, les distances entre chaque bras de commutation 22 des unités électroniques de puissance 20 et le bloc de filtrage 30 sont égales.

Avantageusement, une distance identique entre les unités électroniques de puissance et le bloc de filtrage permet de rendre négligeable ces perturbations électromagnétiques.

Autrement dit, une symétrie entre les distances entre les bras de commutation des unités électroniques de puissance et les unités de filtrage du bloc de filtrage permet d'optimiser la compatibilité électromagnétique entre le convertisseur de tension et la machine électrique.

Le bloc de filtrage 30 peut comprendre au moins deux unités de filtrage 32, par exemple trois unités de filtrage 32 sur les figures 1 et 2. Une unité de filtrage 32 correspond à un groupement d'éléments de filtrage, par exemple deux éléments de filtrage. Comme représenté sur les figures 1 et 2, le bloc de filtrage 30 comprend trois unités de filtrage de deux éléments de filtrage, ici des condensateurs.

La distance minimale entre les bras de commutation 22 d'une unité électronique de puissance 20 et une unité de filtrage 32 peut être sensiblement identique à la distance minimale entre les bras de commutation 22 d'une autre unité électronique de puissance 20 et d'une autre unité de filtrage 32. Par exemple, comme représenté sur les figures 1 et 2, la distance minimale entre les bras de commutation 22 d'une unité électronique de puissance 20 et une unité de filtrage 32 est identique à la distance minimale entre les bras de commutation 22 des deux autres unités électroniques de puissance 20 et des deux autres unités de filtrage 32.

La distance minimale entre chaque bras de commutation 22 de chaque unité électronique de puissance 20 et une unité de filtrage 32 peut être inférieure à 10 mm.

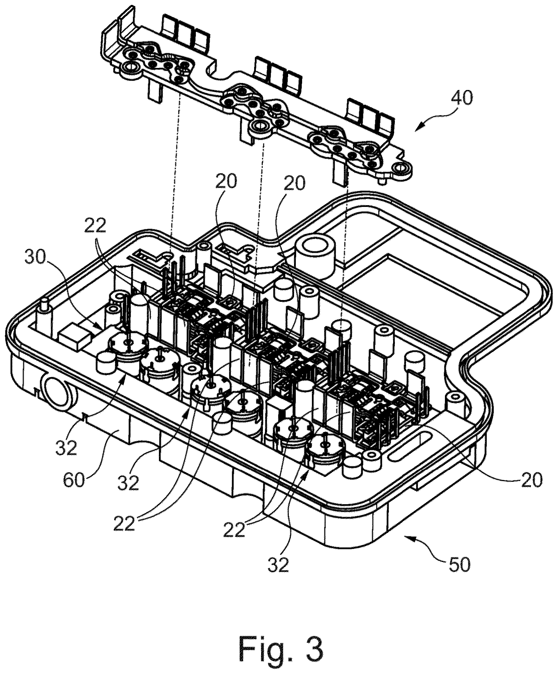

Le convertisseur de tension 10 peut également comprendre un connecteur électrique 40. Un tel convertisseur de tension 10 est par exemple représenté sur les figures 3 (selon l'invention) et 4.

Le connecteur électrique 40 est configuré pour connecter électriquement le bloc de filtrage 30 à chaque bras de commutation 22 de chaque unité électronique de puissance 20.

Le connecteur électrique 40 peut comprendre des traces de puissance. Par exemple, le connecteur électrique 40 peut comprendre une première trace de puissance, par exemple reliée électriquement à un pôle de polarité positive +48V, une deuxième trace de puissance, par exemple reliée électriquement à un pôle de polarité négative -48V ou à la masse de la source d'alimentation électrique, par exemple égale à 0V, et une troisième trace de puissance, par exemple reliée électriquement à une phase (ϕ) de la machine électrique. Les première, deuxième et troisième traces de puissance sont distinctes l'une de l'autre et peuvent être en partie surmoulées de matériau isolant électriquement, par exemple de matériau plastique.

Comme représenté sur les figures 1 et 3, le convertisseur de tension 10 comprend trois unités électroniques de puissance 20 agencées les unes à côté des autres. Autrement dit, les trois unités électroniques de puissance 20 sont alignées les unes à côté des autres.

Le bloc de filtrage 30 s'étend longitudinalement le long de la direction d'agencement des unités électroniques de puissance 20.

Les distances entre chaque bras de commutation 22 de chaque unité électronique de puissance 20 et le bloc de filtrage 30 peuvent être sensiblement identiques.

Autrement dit, le bloc de filtrage 30 s'étend sensiblement parallèlement à la direction d'alignement des unités électroniques de puissance 20 de sorte que les distances entre chaque bras de commutation 22 de chaque unité électronique de puissance 20 et le bloc de filtrage 30 sont sensiblement identiques.

Plus précisément, comme représenté sur la figure 3, la distance entre les bras de commutation 22 d'une unité électronique de puissance 20 et une unité de filtrage 32 du bloc de filtrage 30 est égale à la distance entre les bras de commutation 22 d'une autre unité électronique de puissance 20 et d'une autre unité de filtrage 32 du bloc de filtrage 30.

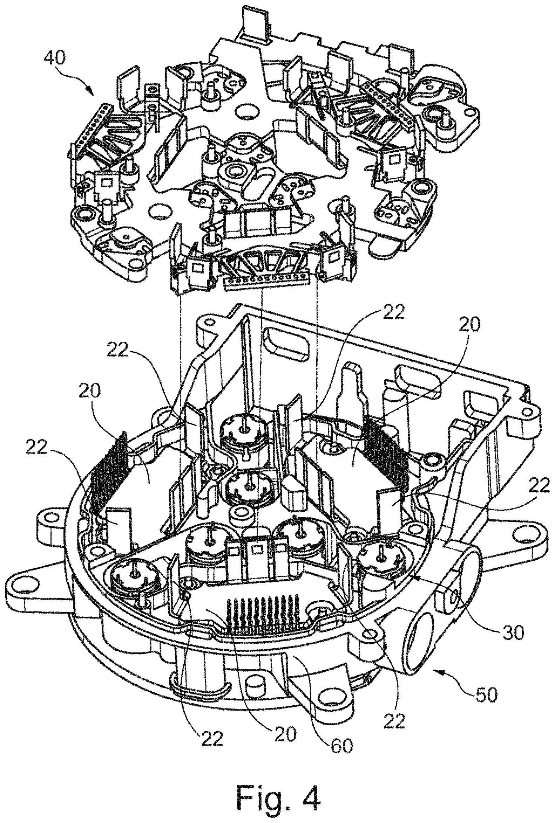

Comme représenté sur les figures 2 et 4, le bloc de filtrage 30 comprend au moins une unité de filtrage 32 agencée telle que les unités électroniques de puissance 20 sont séparées par l'une unité de filtrage 32. Les distances minimales entre chaque bras de commutation 22 et l'unité de filtrage 32 peuvent être sensiblement identiques.

Le convertisseur de tension 10 peut comprendre au moins trois unités électroniques de puissance 20 et le bloc de filtrage 30 peut comprendre au moins trois unités de filtrage 32.

Une unité électronique de puissance 20 peut être séparée d'une autre unité électronique de puissance 20 par une unité de filtrage 32 de sorte que les distances minimales entre chaque bras de commutation 22 de chaque unité électronique de puissance 20 et une unité de filtrage 32 sont sensiblement identiques.

En particulier, les unités électroniques de puissance 20 peuvent être régulièrement réparties le long d'une courbe fermée, et une unité de filtrage 32 peut être disposée entre deux unités électroniques de puissance 20 successives.

Autrement dit, le bloc de filtrage présente une forme en étoile, notamment en étoile à trois branches. Une branche du bloc de filtrage comprend une unité de filtrage. Les branches de la forme en étoile s'étendent radialement depuis un point central du bloc de filtrage et sont régulièrement espacées. Chaque unité électronique de puissance est agencée entre deux branches de la forme en étoile du bloc de filtrage, de sorte qu'une branche de la forme en étoile sépare deux unités électroniques de puissance.

Le convertisseur de tension 10 peut également comprendre un dissipateur thermique 50, notamment visible sur les figures 3 et 4.

Le dissipateur thermique 50 peut comprendre un support de réception 60 des unités électroniques de puissance 20 et du bloc de filtrage 30.

Le support de réception 60 peut comprendre une cavité de réception du bloc de filtrage 30 et une zone de réception des unités électroniques de puissance 20.

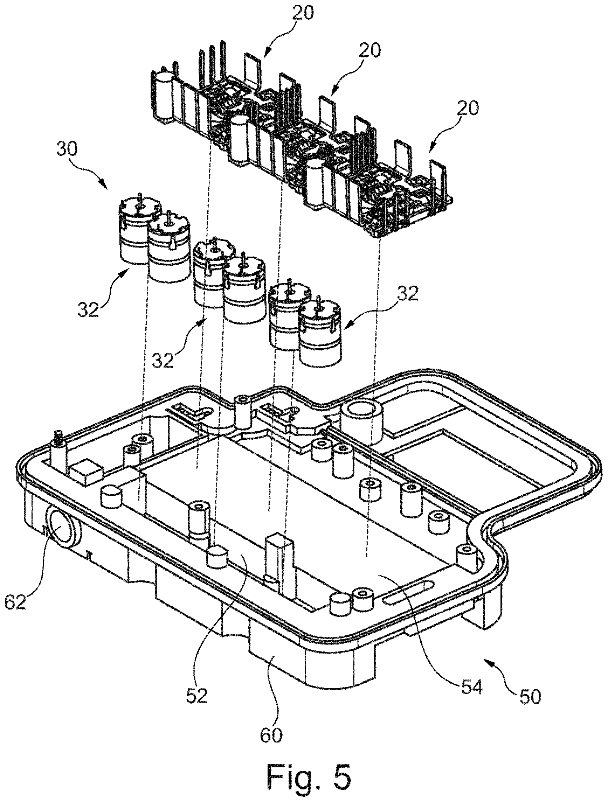

Par exemple, sur la figure 5, le support de réception 60 comprend une cavité 52 de réception des trois unités de filtrage 32 du bloc de filtrage 30 et une zone de réception 54 des unités électroniques de puissance 20.

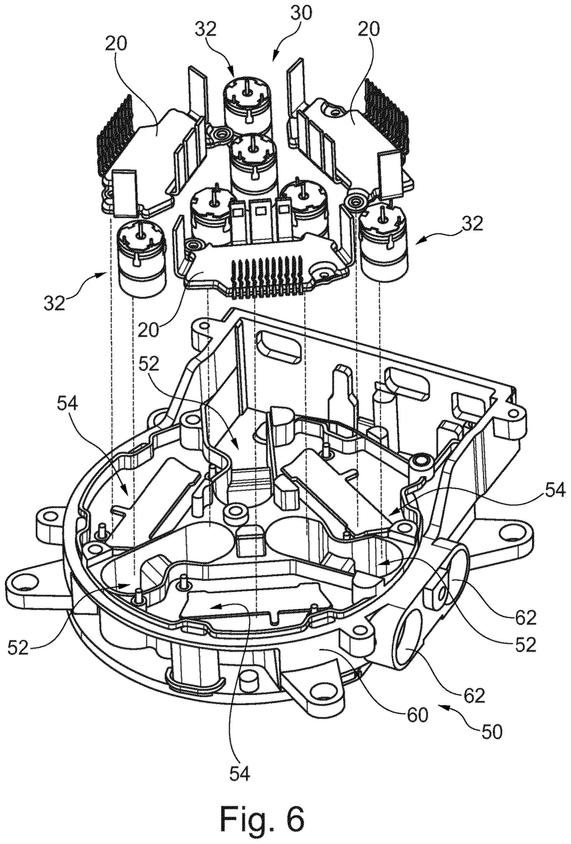

Sur la figure 6, le support de réception 60 comprend trois cavités de réception 52 du bloc de filtrage 30, chaque cavité de réception 52 recevant une unité de filtrage 32, et trois zones de réception 54 des unités électroniques de puissance 20, chaque zone de réception 54 recevant une unité électronique de puissance 20.

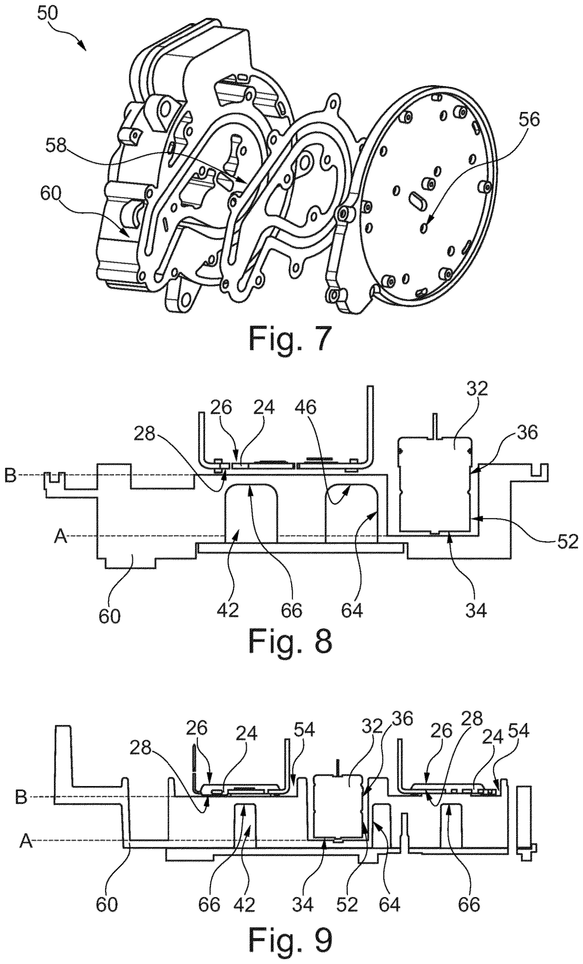

Le dissipateur thermique 50 peut également comprendre un couvercle 56 et un joint métallique 58, notamment représentés en figure 7. Autrement dit, le dissipateur thermique 50 peut être réalisé en trois parties.

De préférence, le dissipateur thermique est réalisé en matériau conducteur électriquement, par exemple en aluminium. Le support de réception 60 et le couvercle 56 peuvent être réalisés par injection sous pression, et assemblés à l'aide du joint métallique 58. Plus précisément, le joint métallique 58 peut être agencé entre le support de réception 60 et le couvercle 56.

Avantageusement, un tel dissipateur thermique présente des parois fines, ce qui permet de diminuer le poids et l'encombrement général du convertisseur de tension et d'améliorer les échanges thermiques entres les unités électroniques de puissance et le dissipateur thermique.

En outre, un tel dissipateur thermique permet une réduction des coûts de production du convertisseur de tension, notamment grâce à une réduction du coût des matériaux et l'utilisation de procédé de fabrication moins coûteux, par exemple des procédés de fabrication ne nécessitant pas d'une étape supplémentaire d'usinage.

Le dissipateur thermique 50 peut comprendre un circuit de refroidissement 62 comportant un canal de circulation d'un fluide de refroidissement. Par exemple, des ports d'entrée et de sortie du circuit de refroidissement 62 sont représentés sur les figures 5 et 6.

Un tel circuit de refroidissement permet d'avoir un débit de fluide, notamment d'eau, de 14 litres par minutes, avec une perte de charge inférieure à 80mbar. Un tel circuit de refroidissement permet d'assurer un débit permanent dans le convertisseur de tension.

Avantageusement, le dissipateur thermique comprenant un circuit de refroidissement permet un refroidissement efficace des unités électroniques de puissance et du bloc de filtrage au sein du convertisseur de tension.

Comme représenté sur les figures 8 et 9, une unité de filtrage 32 du bloc de filtrage peut comprendre une partie inférieure 34 sensiblement plane agencée en vis-à-vis du fond de la cavité de réception 52 du support de réception 60. En particulier, un matériau isolant électriquement, par exemple de la colle thermique, peut être présent entre l'unité de filtrage 32 et le fond de la cavité de réception 52 du support de réception 60. Autrement dit, la partie inférieure 34 de l'unité de filtrage 32 peut être en contact avec un matériau isolant électriquement déposé sur le fond de la cavité de réception 52 du support de réception 60.

Une unité de filtrage 32 peut également comprendre une paroi latérale 36 s'étendant depuis la partie inférieure 34 dans une direction sensiblement perpendiculaire à ladite partie inférieure 34.

Autrement dit, une unité de filtrage 32 peut avoir une forme sensiblement cylindrique comprenant deux bases reliées par une paroi latérale.

Le circuit de refroidissement peut comprendre une première portion 64 s'étendant sensiblement parallèlement à la paroi latérale 36 de l'une unité de filtrage 32. La première portion 64 du circuit de refroidissement 62 peut comprendre une face externe d'une paroi latérale du canal de circulation du fluide de refroidissement.

De préférence, la première portion 64 du circuit de refroidissement 62 est adjacente à la paroi latérale 36 de l'unité de filtrage 32. En particulier, le circuit de refroidissement 62 est agencé de sorte à refroidir la paroi latérale 36 de l'unité de filtrage 32.

Avantageusement, le circuit de refroidissement agencé de sorte à refroidir les parois latérales des unités de filtrage, plutôt que les parties inférieures des unités de filtrage, permet de simplifier le procédé de fabrication du convertisseur de tension, sans induire une perte de charge au niveau des unités de filtrage.

Comme représenté sur les figures 8 et 9, une unité électronique de puissance 20 peut comprendre un substrat plan 24 comprenant une face supérieure 26 et une face inférieure 28. De préférence, la face inférieure 28 de chaque unité électronique de puissance 20 peut être agencée en vis-à-vis de la zone de réception 54 du dissipateur thermique 50. En particulier, un matériau isolant électriquement, par exemple de la colle thermique, peut être présent entre chaque unité électronique de puissance 20 et la zone de réception 54 du dissipateur thermique 50. Autrement dit, la face inférieure 28 de chaque unité électronique de puissance 20 peut être en contact avec un matériau isolant électriquement déposé sur la zone de réception 54 du dissipateur thermique 50.

Le circuit de refroidissement peut comprendre une deuxième portion 66 s'étendant sensiblement parallèlement à la face inférieure 28 de chaque unité électronique de puissance 20. La deuxième portion 66 du circuit de refroidissement peut comprendre une face externe d'une paroi de fond du canal de circulation du fluide de refroidissement. Le circuit de refroidissement est agencé de sorte à refroidir la face inférieure 28 de chaque unité électronique de puissance 20.

En particulier, l'unité électronique de puissance 20, la cavité de réception 52 et la deuxième portion 66 du circuit de refroidissement 62 peuvent être superposés les uns sur les autres.

Le support de réception 60 peut comprendre un premier plan d'appui et un deuxième plan d'appui, respectivement notés A et B sur les figures 8 et 9.

En particulier, les premier et deuxième plans d'appui A, B du support de réception 60 s'étendent sur différentes hauteurs. Autrement dit, les premier et deuxième plans d'appui A, B s'étendent parallèlement l'un par rapport à l'autre.

Le premier plan d'appui A peut comprendre au moins une cavité de réception 52 du bloc de filtrage 30.

Le deuxième plan d'appui B peut comprendre au moins une zone de réception 54 d'une unité électronique de puissance 20.

Le circuit de refroidissement 62 peut comprendre première partie s'étendant sensiblement parallèlement au premier plan d'appui A et une deuxième partie s'étendant sensiblement parallèlement au deuxième plan d'appui B.

Comme les unités de filtrage 32 du bloc de filtrage 30 ne présentent pas les mêmes dimensions que les unités électroniques de puissance 20, les unités électroniques de puissance 20 sont disposées sur le deuxième plan d'appui B, tandis que les unités de filtrage 32 sont disposées sur le premier plan d'appui A.

La différence de hauteur entre les premier et deuxième plans d'appui A, B permet de compenser la différence de dimensions entre les unités électroniques de puissance 20 et le bloc de filtrage.

En particulier, le convertisseur de tension comprenant un connecteur électrique, la distance entre le connecteur électrique et une unité électronique de puissance est sensiblement égale à la distance entre le connecteur électrique et une unité de filtrage.

Avantageusement, la différence de hauteur entre les plans d'appui des unités électroniques de puissance et des unités de filtrage permet de minimiser la longueur de la trace de puissance du connecteur électrique reliant électriquement une unité de filtrage à une unité électronique de puissance, et ainsi de limiter les perturbations électromagnétiques susceptibles d'être générées au sein du convertisseur de tension.

En outre, la différence de hauteur entre les plans d'appui des unités électroniques de puissance et des unités de filtrage permet d'éviter l'intégration de condensateurs en céramique au sein des unités électroniques de puissance.

Le convertisseur de tension selon l'invention a été décrit dans le cadre d'un véhicule automobile. Bien entendu, l'invention n'est nullement limitée aux modes de réalisation décrits et illustrés, qui n'ont été donnés qu'à titre d'exemples. Au contraire, d'autres applications du convertisseur de tension conforme à l'invention sont également possibles dans sortir du cadre de l'invention, telle que définie dans les revendications.

## Revendications

1. Convertisseur de tension (10), notamment destiné à alimenter en puissance une machine électrique pour véhicule automobile, comprenant:
- au moins trois unités électroniques de puissance (20) configurées pour convertir une tension électrique, chaque unité électronique de puissance (20) comprenant deux bras de commutation (22),
- un bloc de filtrage (30) configuré pour filtrer la tension électrique d'entrée des au moins trois unités électroniques de puissance (20),
les au moins trois unités électroniques de puissance (20) et le bloc de filtrage (30) étant connectés électriquement via chaque bras de commutation (22) desdites unités électroniques de puissance (20),
dans lequel les distances entre chaque bras de commutation (22) et le bloc de filtrage (30) sont sensiblement identiques, et
dans lequel les au moins trois unités électroniques de puissance (20) sont alignées les unes à côté des autres, le bloc de filtrage (30) s'étendant sensiblement parallèlement à la direction d'alignement des au moins trois unités électroniques de puissance (20) et dans lequel le bloc de filtrage (30) comprend au moins trois unités de filtrage (32) de sorte que la distance minimale entre les bras de commutation (22) d'une des au moins trois unités électroniques de puissance (20) et d'une des au moins trois unités de filtrage (32) est sensiblement identique à la distance minimale respective entre les bras de commutation (22) des autres des au moins trois unités électroniques de puissance (20) et des autres des au moins trois unités de filtrage (32) respectives.

2. Convertisseur de tension selon la revendication 1, dans lequel la distance minimale entre chaque bras de commutation (22) de chaque unité électronique de puissance (20) et une unité de filtrage (32) respective est inférieure à 10 mm.

3. Convertisseur de tension selon l'une des revendications 1 et 2, comprenant également un dissipateur thermique (50) comprenant un support de réception (60) des au moins trois unités électroniques de puissance (20) et du bloc de filtrage (30), le support de réception (60) comprend au moins une cavité de réception (52) du bloc de filtrage (30) et une zone de réception (54) respective de chacune des au moins trois unités électroniques de puissance (20).

4. Convertisseur de tension selon la revendication 3, le dissipateur thermique (50) comprend un circuit de refroidissement (62) comportant un canal de circulation d'un fluide de refroidissement.

5. Convertisseur de tension selon la revendication 4, au moins une des au moins trois unités de filtrage (32) comprenant une partie inférieure (34) sensiblement plane agencée en vis-à-vis du fond de ladite cavité de réception (52) et une paroi latérale (36) s'étendant depuis la partie inférieure (34) dans une direction sensiblement perpendiculaire à ladite partie inférieure (34), le circuit de refroidissement (62) comprenant une première portion (64) s'étendant sensiblement parallèlement à la paroi latérale (36) de l'au moins une des au moins trois unités de filtrage (32), la première portion (64) du circuit de refroidissement (62) étant adjacente à la paroi latérale (36) de l'au moins une des au moins trois unités de filtrage (32).

6. Convertisseur de tension selon la revendication 4 ou 5, dans lequel chaque unité électronique de puissance (20) comprend un substrat plan (24) comprenant une face supérieure (26) et une face inférieure (28), la face inférieure (28) de chaque unité électronique de puissance (20) étant agencée en vis-à-vis de la zone de réception (54) du dissipateur thermique (50), le circuit de refroidissement (62) comprenant une deuxième portion (66) s'étendant sensiblement parallèlement à la face inférieure (28) de chaque unité électronique de puissance (20), l'unité électronique de puissance (20), la zone de réception (54) et la deuxième portion (66) du circuit de refroidissement (62) étant superposés les uns sur les autres.

## Patentansprüche

1. Spannungswandler (10), insbesondere zur Stromversorgung einer elektrischen Maschine für ein Kraftfahrzeug, umfassend:
- mindestens drei Leistungselektronikeinheiten (20), die so konfiguriert sind, dass sie eine elektrische Spannung umwandeln, wobei jede Leistungselektronikeinheit (20) zwei Umschaltarme(22)umfasst,
- einen Filterblock (30), der so konfiguriert ist, dass er die elektrische Eingangsspannung der Leistungselektronikeinheit (20) filtert,
wobei die mindestens drei Leistungselektronikeinheiten (20) und der Filterblock (30) über jeden Umschaltarm (22) der Leistungselektronikeinheiten (20) elektrisch verbunden sind wobei die Abstände zwischen jedem Umschaltarm (22) und dem Filterblock (30) im wesentlichen identisch sind,
wobei die mindestens drei Leistungselektronikeinheiten (20) nebeneinander angeordnet sind, wobei der Filterblock (30) sich in Längsrichtung entlang der Richtung der Anordnung der Leistungselektronikeinheiten (20) im wesentlichen erstreckt, und wobei der Filterblock mindestens drei Filtereinheiten umfasst so dass die minimale Abstände zwischen den Umschaltarmen einer der mindestens drei Leistungselektronikeinheiten und einer der mindestens drei Filtereinheiten im wesentlichen identisch mit dem jeweiligen Mindestabstand zwischen den Umschaltarmen der anderen Leistungselektronikeinheiten (20) und der anderen der mindestens jeweiligen drei Filtereinheiten (32)

2. Spannungswandler nach Anspruch 1, wobei der Mindestabstand zwischen jedem Umschaltarm (22) jeder Leistungselektronikeinheit (20) und einer jeweiligen Filtereinheit (32) weniger als 10 mm beträgt.

3. Spannungswandler nach einem der Ansprüche 1 und 2, der außerdem einen Kühlkörper (50) mit einem Aufnahmeträger (60) für die mindestens drei Leistungselektronikeinheiten (20) und den Filterblock (30) umfasst, wobei der Aufnahmeträger (60) mindestens einen Aufnahmeraum (52) für den Filterblock (30) und einen jeweiligen Aufnahmebereich (54) für jede Leistungselektronikeinheit (20) umfasst.

4. Spannungswandler nach Anspruch 3, wobei der Kühlkörper (50) einen Kühlkreislauf (62) mit einem Kanal zum Zirkulieren eines Kühlfluids umfasst.

5. Spannungswandler nach Anspruch 4 , wobei mindestens eine der mindestens drei Filtereinheiten (32) einen unteren Teil (34) umfasst, der im Wesentlichen flach gegenüber dem Boden des Aufnahmeraumes (52) angeordnet ist, und eine Seitenwand (36) umfasst, die sich von dem unteren Teil (34) in einer Richtung im wesentlichen senkrecht zu dem unteren Teil (34) erstreckt, wobei der Kühlkreislauf (62) einen ersten Abschnitt (64) umfasst, der sich im wesentlichen parallel zur Seitenwand (36) der mindestens eine der mindestens drei Filtereinheiten (32) erstreckt, wobei der erste Abschnitt (64) des Kühlkreislaufs (62) an die Seitenwand (36) der mindestens eine der mindestens drei Filtereinheiten (32) angrenzt.

6. Spannungswandler nach einem der Ansprüche 4 oder 5, wobei jede Leistungselektronikeinheit (20) ein ebenes Substrat (24) mit einer Oberseite (26) und einer Unterseite (28) umfasst, wobei die Unterseite (28) jeder Leistungselektronikeinheit (20) gegenüber dem Aufnahmebereich (54) des Kühlkörpers (50) angeordnet ist. wobei der Kühlkreislauf (62) einen zweiten Abschnitt (66) umfasst, der sich im wesentlichen parallel zur Unterseite (28) jeder Leistungselektronikeinheit (20) erstreckt, wobei die Leistungselektronikeinheit (20), der Aufnahmebereich (54) und der zweite Abschnitt (66) des Kühlkreislaufs (62) übereinander angeordnet sind.

## Claims

1. Voltage converter (10), in particular intended to supply power to an electrical machine for a motor vehicle, comprising:
- at least three electronic power units (20) configured to convert an electrical voltage, each electronic power unit (20) comprising two switching arms (22),
- a filtering block (30) configured to filter the input electrical voltage of the electronic power unit (20),
the at least three power electronic units (20) and the filter block (30) being electrically connected via each switching arm (22) of said power electronic units (20),
in which the distances between each switching arm (22) and the filter block (30) are substantially identical,
in which the at least three power electronic units (20) are aligned next to each other, the filter block (30) extending noticeably parallel along the direction of alignment of the at least three power electronic units (20), and in which the filtering block comprises at least three filtering units so that the minimum distance between the switching arms (22) of one of the at least three power electronic units (20) and one of the at least three filtering units (32) is noticeably identical to the minimum respective distance of the switching arms of the other ones of the power electronic units (20) and of the other ones of the respective at least three filtering units (32)

2. Voltage converter of claim 1, in which the minimum distance between each switching arm (22° of each power electronic unit (20) and a respective filtering unit (32) is less than 10 mm.

3. Voltage converter of one of claims 1 and 2, further comprising a heat sink (50) comprising a receiving support (60) of the at least three electronic power units (20) and of the filter block (30), the receiving support (60) comprises at least one receiving cavity (52) of the filter block (30) and a respective receiving zone (54) of each electronic power unit (20).

4. Voltage converter of claim 3, the heat sink (50) comprising a cooling circuit (62) comprising a channel for circulating a cooling fluid.

5. Voltage converter of claim 4, at least one of the at least three filtering units (32) comprising a lower part (34) substantially flat arranged opposite the bottom of said receiving cavity (52) and a side wall (36) extending from the lower part (34) in a direction substantially perpendicular to said lower part (34), the cooling circuit (62) comprising a first portion (64) extending substantially parallel to the side wall (36) of the at least one of the at least three filtering units (32), the first portion (64) of the cooling circuit (62) being adjacent to the side wall (36) of the at least one of the at least three filtering units (32).

6. Voltage converter of claim 4 or claim 5, in which each electronic power unit (20) comprises a planar substrate (24) comprising an upper face (26) and a lower face (28), the lower face (28) of each electronic power unit (20) being arranged opposite the reception zone (54) of the heat sink (50), the cooling circuit (62) comprising a second portion (66) extending substantially parallel to the lower face (28) of each electronic power unit (20), the electronic power unit (20), the reception zone (54) and the second portion (66) of the cooling circuit (62) being superimposed on each other.
